# EUROPEAN PATENT APPLICATION

(11) **EP 4 502 730 A1**
(43) Date of publication of application: **05.02.2025**
(21) Application number: 24191265.8
(22) Date of filing: 26.07.2024
(51) Int. Cl.: G03F 7/16, G06N 10/40, H01L 21/67, H10N 60/01

(54) **FILM DEPOSITION METHOD, METHOD FOR MANUFACTURING DEVICE, AND FILM DEPOSITION APPARATUS**

(30) Priority: 31.07.2023 JP 2023125003
(71) Applicant: RIKEN, Wako-shi Saitama 351-0198 (JP)
(72) Inventor: HAYAKAWA, Harumi, Saitama 351-0198 (JP); KUSUYAMA, Koichi, Saitama 351-0198 (JP)
(74) Representative: Cabinet Laurent & Charras

(57) **Abstract**

A film deposition method of the present invention includes: a first step of installing a substrate (100) on a turntable (102) of a spin coating device such that a first main surface (100a) faces the turntable, and adding a first liquid having viscosity dropwise onto a second main surface (100b) of the substrate; a second step of holding the substrate in the same state until the first liquid added dropwise reaches the first main surface (100a) side from the second main surface (100b) side through a through-hole (101); a third step of rotating the substrate (100) together with the turntable (102); and a fourth step of heating the first liquid together with the substrate (100).

## Description

### BACKGROUND OF THE INVENTION

### Field of the Invention

The present invention relates to a film deposition method, a method for manufacturing a device, and a film deposition apparatus.

Priority is claimed on Japanese Patent Application No. 2023-125003, filed on July 31, 2023, the content of which is incorporated herein by reference.

### Description of Related Art

In recent years, a three-dimensional device structure in which through-holes are installed on a substrate has been attracting attention in the manufacturing of three-dimensional mounting of semiconductor integrated circuits, micromachines (MEMS) such as semiconductor sensors, devices for quantum computers, and the like. In such a three-dimensional device, in a lithography step after the through-hole is opened, deterioration in pattern dimensional accuracy due to the deterioration in film thickness uniformity of a resist film caused by the presence of the through-hole has been a problem. In some three-dimensional devices, it is also possible to manufacture the device by applying the conventional manufacturing process technology by closing the inside of the through-hole using a CVD method or the like and planarizing the substrate using a CMP technique or the like. However, in micromachines, particularly in devices provided with a liquid flow path and devices for quantum computers, a structure using the through-hole itself may be adopted, and in such a device, since it is necessary to reopen the through-hole in the final stage when the through-hole opened on the substrate is closed to manufacture the device, the closing of the through-hole is unreasonable from the viewpoint of the manufacturing process. Therefore, there is an expectation for the development of a manufacturing process that allows the manufacturing process to be continued after the through-holes have been opened while keeping the through-holes open.

In recent years, quantum computers, which perform calculations using qubits, have been attracting attention. One well-known method for realizing qubits is the superconducting circuit method, which allows integration. In the superconducting circuit method, the energy levels of a harmonic oscillator configured using Josephson junctions are quantized at low temperatures to form a qubit using a two-level system. In order to operate the quantum computer, a large number of qubits are required, and a large number of superconducting circuits for generating the qubits are required. However, the circuit mounting space on a substrate is limited, and interference between circuits integrated on the substrate is likely to occur, which is a problem. As a solution to this problem, means for connecting a ground pattern on the front surface of a substrate surface and a ground pattern on the back surface of a substrate with a large number of through-substrate vias to suppress the influence of microwave noise emitted from a qubit element as much as possible is used (Patent Document 1).

The through-hole via may be formed after the superconducting circuit is formed, but it is necessary to perform a plasma treatment when forming a through-hole (via) for the through-hole via and there is a possibility that the superconducting circuit, particularly the Josephson junction part, may be damaged by this treatment. On the contrary, it is difficult to form the through-hole via before forming the superconducting circuit. This is because, on a substrate in a state where the through-hole is formed, it is difficult to form a film having sufficient film thickness uniformity, and a variation in the resist film thickness occurs at a part where the Josephson junction is formed, which causes a variation in the manufacturing of the superconducting circuit.

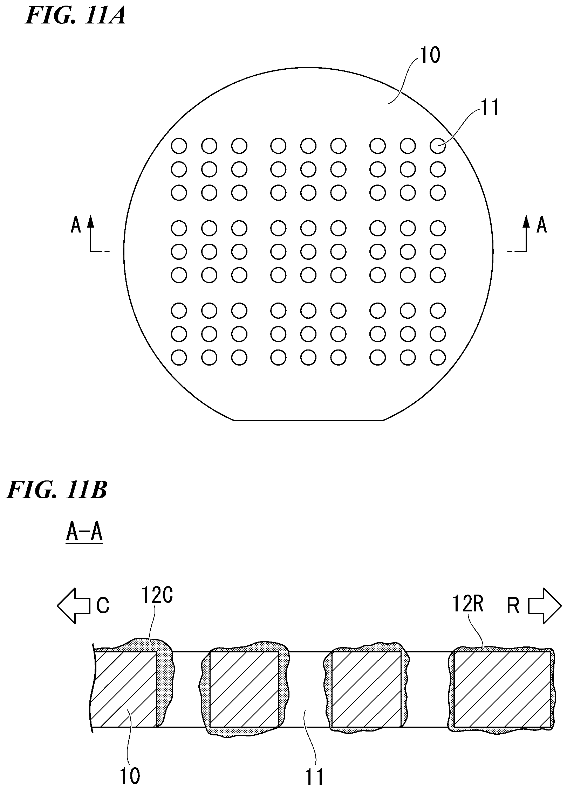

In a substrate 10 having a through-hole 11 as shown in FIG. 11A, when the resist is rotationally applied, the resist moves from the rotation center side towards the substrate outer periphery by centrifugal force. At this time, when the flow of the resist encounters the inner wall of the through-hole 11 on the outer peripheral side of the substrate, the flow is influenced by gravity, and enters the through-hole 11, in other words, towards the back surface side, reducing the supply amount of the resist to the outer peripheral side of the through-hole 11. As a result, as shown in FIG. 11B in which the cross section of the substrate 10 is enlarged, there is a problem that the film thickness of a resist film 12R on the substrate 10 at a substrate outer peripheral portion side R from the through-hole 11 is thinner than the film thickness of a resist film 12C on the substrate 10 at the through-hole 11 from a substrate center portion side C.

### [Citation List]

### [Patent Documents]

[Patent Document 1] Japanese Patent No. 7133842
[Patent Document 2] Japanese Unexamined Patent Application, First Publication No. S54-009919

### SUMMARY OF THE INVENTION

The present invention has been made in view of the above circumstances, and an object of the present invention is to provide a film deposition method which makes it possible to improve the film thickness uniformity of a thin film in a thin film coating film deposition method of forming a film by adding a liquid for forming a thin film dropwise onto a substrate having a through-hole, a method for manufacturing a device using the same, and a film deposition apparatus.

In order to solve the above-described problem, the present invention employs the following means.
(1) According to an aspect of the present invention, a film deposition method for forming a film on a first main surface of a substrate having a through-hole, the method includes: a first step of installing the substrate on a turntable of a spin coating device such that the first main surface faces the turntable, and adding a first liquid having viscosity dropwise onto a second main surface of the substrate; a second step of holding the substrate in the same state until the first liquid added dropwise reaches the first main surface side from the second main surface side through the through-hole; a third step of rotating the substrate together with the turntable; and a fourth step of heating the first liquid together with the substrate.
(2) In the film deposition method according to above (1), the first step includes a step of adding a second liquid dropwise onto the entire surface of the substrate before the first liquid is added dropwise, the second liquid consisting of a solvent that improves affinity of a liquid for forming a thin film on the second main surface, the surface of the through-hole, and the first main surface.
(3) In the film deposition method according to above (2), the solvent that improves the affinity of the second liquid may be a solvent of the first liquid.
(4) In the film deposition method according to any one of above (1) to (3), the rotation in the third step may be performed in a state where the second main surface side of the substrate is covered with a lid.
(5) In the film deposition method according to above (4), the lid that covers the second main surface side of the substrate may rotate in synchronization with the substrate.
(6) In the film deposition method according to any one of above (1) to (5), a fifth step of installing the second main surface to face the turntable of the spin coating device and adding a third liquid dropwise onto the first main surface of the substrate; and a sixth step of heating the third liquid, may further be provided, after the fourth step.
(7) In the film deposition method according to above (6), the same liquid as the first liquid may be used as the third liquid.
(8) According to another aspect of the present invention, a method for manufacturing a device is a method for manufacturing a device using the film deposition method according to above (6) or (7), and a predetermined circuit is formed using a film formed by curing the first liquid through the fourth step and a film formed by curing the third liquid through the sixth step.
(9) In the method for manufacturing a device according to above (8), the first liquid may be a copolymer, and the third liquid may be an electron beam resist.
(10) In the method for manufacturing a device according to above (9), a solute of the first liquid may be a copolymer of methyl methacrylate acid and methacrylic acid (copolymer of MMA/MAA), and a solvent of the first liquid may be ethyl lactate.
(11) In the method for manufacturing a device according to above (9), a solute of the third liquid may be a polymethyl methacrylate resin (PMMA) and a solvent of the third liquid may be chlorobenzene or anisole, or the solute of the third liquid may be a methyl styrene/chloromethyl acrylate copolymer and the solvent of the third liquid may be anisole.
(12) In the method for manufacturing a device according to any one of above (8) to (11), the circuit may be a superconducting circuit including a Josephson junction.
(13) According to still another aspect of the present invention, a film deposition apparatus used in the film deposition method according to any one of above (1) to (5), the turntable of the spin coating device facing the first main surface has no unevenness at least on a surface of a part facing the first main surface.

According to the present invention, a film deposition method which makes it possible to form a film with improved film thickness uniformity of a thin film in a thin film coating film deposition method of forming a film by adding a liquid for forming a thin film dropwise onto a substrate having a through-hole, a method for manufacturing a device using the same, and a film deposition apparatus can be provided.

### BRIEF DESCRIPTION OF THE DRAWINGS

FIG. 1A is a plan view of a substrate on which a film is formed by a film deposition method according to an embodiment of the present invention.
FIG. 1B is a cross-sectional view of the substrate of FIG. 1A in a state of being set in a spin coating device.
FIG. 2A is a plan view of a turntable used in the film deposition method according to the embodiment.
FIG. 2B is a plan view of a turntable used in the film deposition method according to the embodiment.
FIG. 3A is a cross-sectional view of the substrate and the spin coating device in each step of the film deposition method according to the embodiment.
FIG. 3B is a cross-sectional view of the substrate and the spin coating device in each step of the film deposition method according to the embodiment.
FIG. 3C is a cross-sectional views of the substrate and the spin coating device in each step of the film deposition method according to the embodiment.
FIG. 4A is a cross-sectional view of the substrate and the spin coating device in each step of the film deposition method according to the embodiment.
FIG. 4B is a cross-sectional view of the substrate and the spin coating device in each step of the film deposition method according to the embodiment.
FIG. 4C is a cross-sectional view of the substrate and the spin coating device in each step of the film deposition method according to the embodiment.
FIG. 5 is a cross-sectional view of the substrate and the spin coating device in each step of the film deposition method according to the embodiment.
FIG. 6A is an image in which a part of the substrate after the fourth step and a part of the substrate after the sixth step in the film deposition method of Example 1 is enlarged.
FIG. 6B is an image in which a part of the substrate after the fourth step and a part of the substrate after the sixth step in the film deposition method of Example 1 is enlarged.
FIG. 7A is an image in which a part of the substrate after the fourth step and a part of the substrate after the sixth step in the film deposition method of Example 2 is enlarged.
FIG. 7B is an image in which a part of the substrate after the fourth step and a part of the substrate after the sixth step in the film deposition method of Example 2 is enlarged.
FIG. 8 is an image in which a part of a substrate on which the film is formed in the film deposition method of Comparative Example 1.
FIG. 9A is a diagram showing distribution of electrical resistance values in a thickness direction for each chip cut out from the film-formed substrate of Comparative Example 1.
FIG. 9B is a diagram showing distribution of electrical resistance values in a thickness direction for each chip cut out from the film-formed substrate of Comparative Example 1.
FIG. 9C is a diagram showing distribution of electrical resistance values in a thickness direction for each chip cut out from the film-formed substrate of Comparative Example 1.
FIG. 9D is a diagram showing distribution of electrical resistance values in a thickness direction for each chip cut out from the film-formed substrate of Comparative Example 1.
FIG. 9E is a diagram showing distribution of electrical resistance values in a thickness direction for each chip cut out from the film-formed substrate of Comparative Example 1.
FIG. 9F is a diagram showing distribution of electrical resistance values in a thickness direction for each chip cut out from the film-formed substrate of Comparative Example 1.
FIG. 9G is a diagram showing distribution of electrical resistance values in a thickness direction for each chip cut out from the film-formed substrate of Comparative Example 1.
FIG. 9H is a diagram showing distribution of electrical resistance values in a thickness direction for each chip cut out from the film-formed substrate of Comparative Example 1.
FIG. 10 is a diagram showing distribution of electrical resistance values in the thickness direction at a part of the film-formed substrate of Example 1.
FIG. 11A is a plan view of a substrate on which a through-hole is formed according to the related art.
FIG. 11B is a view in which a part of a cross-section of the part shown by line A-A in FIG. 11A.

### DETAILED DESCRIPTION OF THE INVENTION

Hereinafter, a film deposition method, a method for manufacturing a device, and a film deposition apparatus according to an embodiment to which the present invention is applied will be described in detail with reference to the accompanying drawings. In the drawings used in the following description, in order to make features easier to understand, a characteristic portion will be enlarged for convenience in some cases, and a dimensional ratio or the like of each component is not necessarily the same as the actual one. In addition, materials, dimensions, and the like mentioned in the following description are examples, and the present invention is not limited thereto and can be implemented with appropriate modifications within the scope of the present invention.

### <First Embodiment>

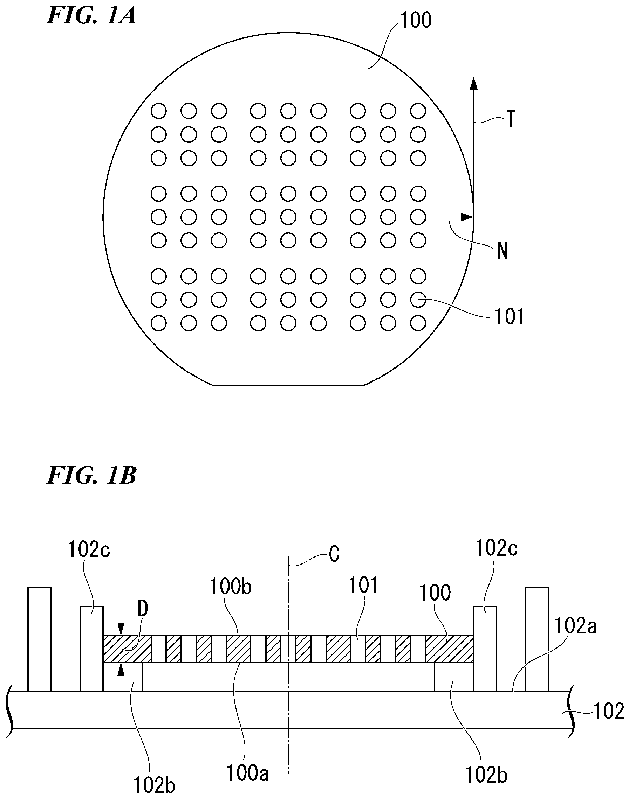

FIG. 1A is a plan view of a substrate (a film-forming substrate, a wafer) 100 on which a film is formed by a film deposition method according to an embodiment of the present invention. The substrate 100 has two flat main surfaces 100a and 100b and one or more through-holes 101 that penetrate the substrate 100 in a thickness direction D. A material of the substrate 100 is not particularly limited, and examples thereof include semiconductors such as silicon, sapphire, and glass. The shape, size, arrangement, and the like of the through-hole 101 are designed in accordance with a circuit structure to be formed after film deposition.

In addition, depending on the device to be manufactured, the film can also be formed on a substrate 100 on which a thin film for forming electrical wiring or superconducting wiring, an insulating film, or the like is formed in advance on a first main surface 100a.

The film deposition method according to the present embodiment is a method of forming a film on the first main surface 100a of the substrate 100 having the through-hole 101, and mainly includes the following first step to sixth step in sequence.

### (First Step)

FIG. 1B is a cross-sectional view of the film deposition apparatus in a state where the substrate 100 is set in the spin coating device. Here, only the vicinity of the part of the spin coating device where the substrate 100 is installed is shown. First, as shown in FIG. 1B, a substrate 100 is installed on a turntable 102 of the spin coating device such that a first main surface 100a on which the film is formed faces the turntable 102 (here, faces downward). It is preferable that the surface of the turntable 102 of the spin coating device, which faces the first main surface 100a, have no unevenness (is substantially flat) at least at the part facing the first main surface 100a.

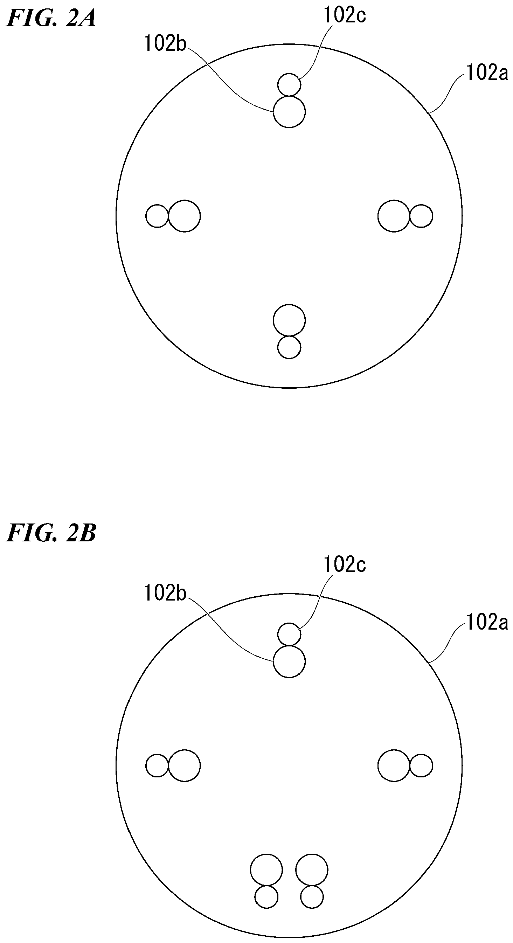

FIGS. 2A and 2B are plan views showing a configuration example of the turntable 102. The turntable 102 includes a substrate support portion (pad) 102b that supports the substrate 100 on a substantially flat surface 102a on the side on which the substrate is installed. The substrate support portion 102b may be configured to be arranged symmetrically with respect to a rotation axis C of the turntable 102, as shown in FIG. 2A. In addition, in a state where the substrate 100 is installed, the substrate support portions 102 are all uniform in height from one surface 102a of the turntable such that the film-forming surface of the substrate 100 is not tilted with respect to the rotation axis C, that is, such that the film-forming surface is orthogonal to the rotation axis C. A part of a first main surface 100a of the substrate, which is not supported by the substrate support portion 102b, is spaced apart from one surface 102a of the turntable.

When a recess portion for installing a screw for connecting the turntable to the rotation axis is provided at a center part of the turntable, the film thickness uniformity of the thin film formed in the vicinity of the center portion of the substrate on the main surface 100b deteriorates due to the disturbance of the airflow in the vicinity of the recess portion or the like, and a thick part (protrusion portion) of the thin film formed by a first liquid 103 is created at the opening portion of the through-hole 101 on the main surface 100b side in the vicinity of the center portion of the substrate, and the amount of the first liquid 103 supplied to the main surface 100a through the through-hole 101 is reduced at the center portion of the substrate. Therefore, it is desirable that the center part of the turntable is flat.

One surface 102a of the turntable further includes a substrate fixing portion (inner pin) 102c that prevents the substrate from slipping during rotation. The substrate fixing portion 102c is configured to be installed in an upright state at a position close to the outermost periphery of the substrate when the substrate 100 is installed, and the position of the top portion of the substrate fixing portion 102c is higher than the position of the film-forming surface of the substrate 100. As shown in FIG. 2B, by arranging some parts of the substrate fixing portions 102c in one direction, the orientation flat portion of the substrate 100 can be fixed at the position of the parts of the substrate fixing portions 102c.

A second liquid (not shown) having affinity may be added dropwise onto a second main surface 100b of the substrate. The second liquid may be added dropwise while moving the coating position from the center to the outer peripheral portion with the substrate 100 rotated by the turntable 102 using the function of the spin coating device, or may be added dropwise while moving the coating position to the entire surface using a liquid coating nozzle, a dropper, or the like of the spin coating device without rotating the substrate. The layer of the second liquid covers substantially the entire the second main surface 100b, substantially the entire surfaces of each through-hole 101, and substantially the entire the first main surface 100a. Since the second liquid is a solvent that does not contain a solute, the second liquid has a lower viscosity than the first liquid 103 because the second liquid does not contain a solute, and can spread over the surface of the substrate 100. The second liquid is a solvent which can improve the affinity, and in a case where the first liquid 103 is the solvent, the solute of the first liquid 103 and the solvent of the second liquid undergo a chemical reaction, preventing the solute of the first liquid 103 from solidifying and generating foreign matter or the like. In addition, in a case where the second liquid is amphiphilic, having both hydrophobic and hydrophilic groups, even when water molecules adhere to the surface of the substrate 100 and the substrate 100 has hydrophilicity, the second liquid forms a molecular layer on the surface of the substrate 100, and accordingly, the first liquid 103 can be improved in affinity even in the case of a liquid that is difficult to apply to a hydrophilic substrate surface, such as an electron beam resist or a photoresist.

Therefore, since the monomolecular layer of the second liquid or the plurality of molecular layers of the second liquid is formed on substantially the entire surface of the substrate 100, it is possible to promote the spreading of the first liquid 103 to be applied in the next step on substantially the entire surface of the substrate 100.

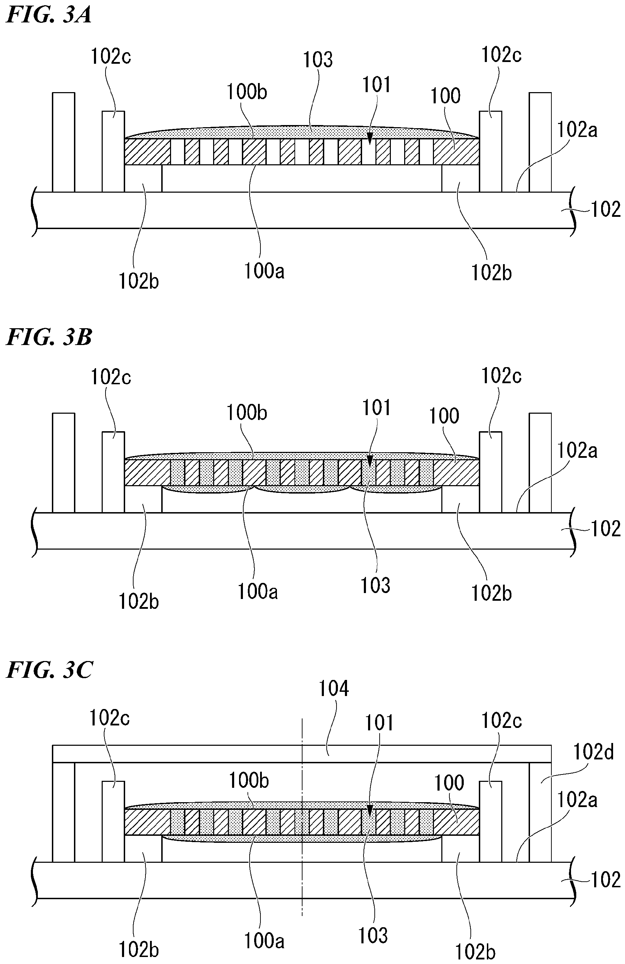

In this state, the first liquid 103 having viscosity is applied to the second main surface 100b of the installed substrate. The first liquid 103 may be applied while moving the coating position from the center to the outer peripheral portion with the substrate 100 rotated by the turntable 102 using the function of the spin coating device, or may be applied while moving the coating position to the entire surface using a liquid coating nozzle, a dropper, or the like of the spin coating device without rotating the substrate. FIG. 3A is a cross-sectional view showing the state of the substrate 100 immediately after the first liquid 103 is applied. The second main surface 100b is entirely covered with a layer of the first liquid 103.

### (Second Step)

Next, the applied first liquid 103 is held without moving the substrate in the same state until the first liquid 103 reaches first main surface 100a side of the substrate through the through-hole 101 from the second main surface 100b side of the substrate. FIG. 3B is a cross-sectional view of a state where the first liquid 103 has reached first main surface 100a side, the through-hole 101 is filled with the first liquid 103, and the first liquid 103 has spread on first main surface 100a side. In addition, when there is no through-hole 101 in the center portion of the substrate 100, it is desirable to hold the first liquid 103 until the first liquid 103 reaches the center portion of the substrate 100 in order to apply the first liquid 103 to the center portion of the substrate 100.

### (Third Step)

Next, the substrate 100 is rotated together with the turntable 102 by using the function of the spin coating device. As a result, the first liquid 103 that has protruded from the opening portions of each through-hole 101 spreads to the periphery along first main surface 100a of the substrate, and a thin film consisting of the first liquid 103 is formed with a thickness determined by the viscosity of the first liquid 103, the rotation speed, the rotation time, and the like. The rotation in the third step may be performed in a state where the second main surface 100b side of the substrate is covered with the lid 104 close to the second main surface 100b side.

At this time, on the second main surface 100b, in a normal line N (refer to FIG. 1A) connecting the center of the substrate 100 and each through-hole 101 and intersecting a tangent line T on the outer periphery, the movement direction of a part of the first liquid 103, which flows due to the centrifugal force generated during rotation from the center direction of the substrate 100, is bent to the lower side (towards the back surface side and the main surface 100a side) of each through-hole 101 by gravity and the like in each through-hole 101. That is, the flow of first liquid 103 collides with the side wall of the inner wall of each through-hole 101 in the outer peripheral direction of the substrate 100, and as a result, a certain amount of first liquid 103 determined by centrifugal force, the diameter of through-hole 101, and gravity is diverted to main surface 100a through each through-hole 101, and on main surface 100b, the supply amount of first liquid decreases in the region from each through-hole 101 towards the substrate outer periphery on the normal line N connecting the center of substrate 100 and each through-hole 101, and the film thickness of the thin film formed in that region becomes thinner than that of the region from each through-hole 101 towards the substrate center on the normal line N connecting the center of substrate 100 and each through-hole 101.

On the other hand, on the main surface 100a, since the first liquid 103 is supplied from each through-hole 101 installed in the substrate 100, the first liquid 103 is supplied from the main surface 100b side to the region of the substrate 100 towards the outer peripheral portion in the normal line N connecting the center of the substrate 100 and each through-hole 101 through each through-hole 101. Therefore, the ratio of the film thickness of the first liquid in the region closer to the center of each through-hole 101 on the normal line N connecting the center of the substrate 100 and each through-hole 101 to the film thickness of the first liquid in the region closer to the outer peripheral side of each through-hole 101 can be improved compared to the case where the main surface 100b is coated using the same method as the conventional coating method.

Therefore, the film thickness of the thin film 103 formed on a first main surface 100a by the first liquid can be made more uniform compared to the film thickness of the thin film 103 formed on a second main surface 100b.

In FI3C, the case of installing the lid 104 in the third step is shown as an example. The lid 104 is supported by a lid support portion (outer pin) 102d that is installed in an upright state on one surface 102a of the turntable. It is preferable that the rotation of the substrate 100 in the third step be performed in such a manner that the second main surface 100b side of the substrate is covered with the lid 104, and is substantially sealed by the lid 104 spaced apart from at least the lid support portion 102d, and the lid 104 covering the second main surface 100b side of the substrate rotates in synchronization with the substrate 100. In this state, the wind received by the first liquid 103 during spreading can be reduced. Therefore, the first liquid 103 can spread uniformly on the first main surface 100a without being biased by the pressure generated by receiving the wind. The lid 104 that covers the second main surface 100b side of the substrate 100 may be configured to rotate in synchronization with the substrate 100.

### (Fourth Step)

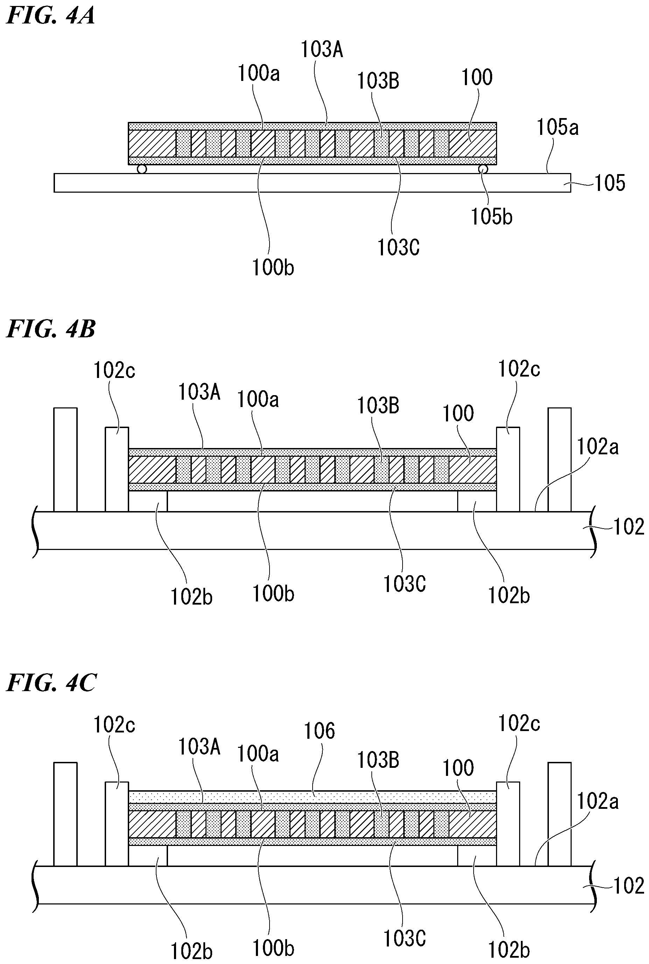

Next, the first liquid 103 supplied into the through-hole 101, on the second main surface 100b, and on the first main surface 100a is heated using heating means 105 such as a hot plate together with the substrate 100. FIG. 4A is a diagram showing a state where the first liquid 103 is cured by heating, and each of the first thin films 103A, 103C, and 103B is formed on the first main surface 100a, the second main surface 100b, and within the through-hole 101. The heating means 105 shown in FIG. 4A as an example is in a flat plate shape, and minute projections 105b are provided on a surface 105a on the side where the substrate 100 is heated. Therefore, the substrate 100 can be heated in a state where the substrate 100 is supported by the minute projection 105b and is not in contact with the heating means 105.

### (Fifth Step)

Next, the substrate 100 is installed on the turntable 102 such that the second main surface 100b faces the turntable 102 in a state where the substrate 100 is turned upside down from the first step to the third step. FIG. 4B is a view showing a state where the substrate 100 is installed. In this case, the first main surface 100a of the substrate is oriented opposite to the turntable 102 (upward) and becomes the film-forming surface.

A third liquid 106, which is a raw material for film deposition, is added dropwise onto the first main surface 100a of the substrate while the substrate 100 is stationary or rotating, and then the substrate 100 is rotated together with the turntable 102 to apply the third liquid 106. As the third liquid 106, for example, there is one that can be cured at a temperature equal to or lower than the melting temperature of the first liquid 103 and has an etching rate with respect to a predetermined etching liquid smaller than that of the first liquid 103. In a case where the same liquid (liquid having the same composition) as the first liquid 103 is used as the third liquid 106, the thickness uniformity of the coating film which can be formed by the first liquid 103 can be further improved as compared with a case where the coating film is formed in a single layer (in a case where the third liquid 106 is not applied).

In the case of forming a Josephson junction used for a quantum computer device or the like, as the first liquid 103, a liquid in which the solute is a copolymer of methyl methacrylate and methacrylic acid (copolymer of MMA/MAA) and the solvent is ethyl lactate is assumed, and as the third liquid 106, an electron beam resist in which the solute is a methyl styrene/chloromethyl acrylate copolymer and the solvent is anisole, or an electron beam resist in which the solute is a polymethyl methacrylate resin (PMMA) and the solvent is chlorobenzene or anisole is assumed.

FIG. 4C is a cross-sectional view showing the state of the substrate 100 immediately after the third liquid 106 is applied. Since the first liquid 103 formed through the fourth step is substantially filled in the through-hole 101 and the through-hole 101 is substantially closed, the third liquid 106 can be applied to the substrate 100 in the same manner as in the case of applying the third liquid 106 to the substrate on which the through-hole is not formed.

### (Sixth Step)

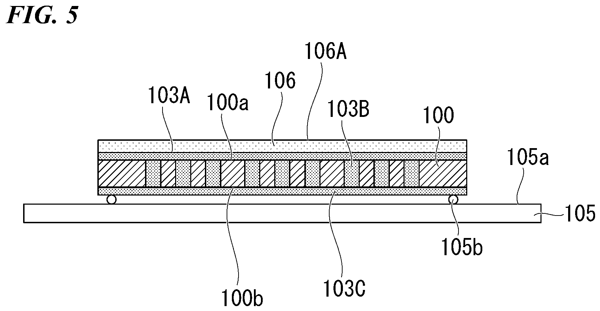

Next, the third liquid 106 supplied onto the first thin film 103A of the first liquid 103 is heated again together with the substrate 100 using the heating means 105 such as a hot plate. FIG. 5 is a view showing a state where the third liquid 106 is cured by heating, and a second thin film 106A consisting of the cured third liquid 106 is formed on the first thin film 103A. As the heating means 105, for example, a heating unit having the same configuration as that shown in FIG. 4A can be used. Since each through-hole 101 is substantially closed by the first liquid 103B, the film thickness uniformity of the second thin film 106A can be improved as compared with a case where each through-hole 101 is not substantially closed by the first liquid 103B.

### (Pretreatment Step)

The substrate 100 before the first step may be subjected to a pretreatment such as a dewater bake treatment or a wettability improvement treatment.

In the dewater bake treatment, the substrate is dewatered at a temperature equal to or higher than the boiling point of water using a hot plate or the like, and then cooled. Regarding the cleaning treatment, in general semiconductor manufacturing steps such as an IC manufacturing step and an LSI manufacturing step, not only the organic solvent cleaning treatment mentioned above but also a wide variety of other methods are performed. Therefore, it may not be particularly necessary to describe this in detail. On the other hand, with regard to the dewater baking, it is known that when water molecules adhere to the surface of the substrate 100, the surface of the substrate 100 becomes hydrophilic, and the adhesion and coatability with organic liquids such as photoresist deteriorates. Dewater baking is performed to remove the water molecules adsorbed from such hydrophilic substrate surfaces and make them hydrophobic, providing good adhesion and coatability to organic liquids.

As the wettability improvement treatment, a solvent (such as ethyl lactate) of a liquid used for film deposition is applied to the entire surface of the substrate 100, including the inner wall surface of the through-hole 101, by the following procedure. First, considering the installation state of the substrate in the subsequent first step, the substrate 100 is installed, and the solvent of the first liquid 103 is applied to the first main surface 100a of the substrate and the through-hole 101. Subsequently, the solvent applied to the rotating substrate 100 is dried. Subsequently, as shown in FIG. 1B, the substrate 100 is inverted and installed such that the second main surface 100b faces upward, and the solvent of the first liquid 103 is applied to the second main surface 100b. Subsequently, the substrate 100 is rotated to dry the applied solvent completely.

In the present treatment, the liquid to be applied is the solvent of the first liquid 103 and does not contain a solute, and thus has a lower viscosity than the first liquid 103. Therefore, the present solvent can cover substantially the entire surface of the substrate 100, including the inner walls of all through-holes 101, with the organic molecules constituting the solvent, and can improve the wettability of the first liquid 103 to be applied in the subsequent step.

By performing the wettability improvement treatment, the wettability of the first liquid 103 to be applied from the first step to the third step is improved on the entire surface of the substrate 100, including the inner wall surface of the through-hole 101, and thus the supply time of the first liquid 103 can be shortened. In particular, due to the effect that the wetting spread into the through-hole 101 is smooth and the effect that the efficiency of the flow of the first liquid 103 is improved, the first liquid 103 can be supplied to the first main surface 100a of the substrate through the through-hole 101 regardless of the design of the through-hole, such as the size (hole diameter, length) and the arrangement.

As described above, in the film deposition method according to the present embodiment, the supply to the film-forming surface (the first main surface 100a) of the substrate 100 is performed through the through-hole 101 in a state where the substrate 100 is directed to the lower side. Since the liquid supplied downward through the through-hole 101 spreads on the film-forming surface with the opening portion of each through-hole 101 as a starting point, the liquid spreads uniformly over the entire the first main surface 100a of the substrate regardless of the distance from the rotation center (rotation axis C) of the substrate 100. Therefore, the liquid can be uniformly supplied to the entire film-forming surface regardless of the size, arrangement, and the like of the through-hole 101, and a flat film can be formed by curing the liquid.

On the other hand, on the first main surface 100a, when the substrate is rotated, the first liquid 103 is supplied from the main surface 100b side to the region of the substrate 100 towards the outer peripheral portion in the normal line N connecting the center of the substrate 100 and each through-hole 101 through each through-hole 101. Therefore, the ratio of the film thickness of the first liquid in the region closer to the center of each through-hole 101 on the normal line N connecting the center of the substrate 100 and each through-hole 101 to the film thickness of the first liquid in the region closer to the outer peripheral side of each through-hole 101 can be improved compared to the case where coating is performed by a conventional method in which the first main surface 100a is the upper surface.

According to the film deposition method of the present embodiment, since the film thickness uniformity can be improved even though the film-forming surface of the substrate has the through-hole 101, it is possible to prevent manufacturing variations due to film thickness variations and prevent a decrease in yield in subsequent steps.

Various devices can be manufactured using the film deposition method according to the present embodiment. That is, a predetermined circuit can be formed by using the film formed by curing the first liquid 103 through the fourth step and the film formed by curing the third liquid 106 through the sixth step. For example, a resist is used as the third liquid 106 after a thin film consisting of a conductive material is formed on the surface of the substrate 100, and a predetermined wiring pattern of a device (circuit (for example, a superconducting circuit including a Josephson junction)) is formed on the second thin film 103A, which is cured through the fourth step, by using a lithography method and an etching method. Subsequently, by repeating such a step, a predetermined device can be manufactured.

At the initial point of the device manufacturing, the through-hole can be formed on the substrate, and then the resist film can be applied in the lithography step without significantly reducing the uniformity of the film thickness of the resist film, and thus it is possible to avoid the problem of a delicate part of the device being damaged by a through-hole formation treatment, such as a long-duration high-temperature plasma treatment, after the formation of the delicate part of the device. For example, by forming the resist pattern using the film deposition method of the present embodiment, the device structure including the superconducting circuit can be formed without prolonged exposure to high-temperature plasma, and the superconducting qubit substrate can be manufactured without damaging the delicate Josephson junction portion.

### [Examples]

Hereinafter, the effects of the present invention will be described in greater detail with reference to Examples. The present invention is not limited to the following Examples, and can be appropriately modified and implemented within the scope not departing from the gist thereof.

### (Example 1)

A two-layer electron beam resist layer consisting of a copolymer of MMA/MAA and a methyl styrene/chloromethyl acrylate copolymer was formed on the first main surface of a substrate having a through-hole by the film deposition method of the embodiment described above. As a substrate, a silicon substrate in which through-holes having pore diameters of 150 µm and 1000 µm are formed was used.

As a pretreatment step, the substrate was rotated at 500 rpm for 60 seconds, and 20 mL of isopropyl alcohol (IPA) was sprayed onto the film-forming surface of the substrate for cleaning. Subsequently, the substrate was rotated at 2000 rpm for 30 seconds to dry the cleaning liquid. Subsequently, the dewater baking was performed on the substrate using a hot plate or the like at 110°C for 180 seconds, followed by natural cooling.

In the first step, first, while rotating the substrate at 500 rpm for 60 seconds, 20 mL of ethyl lactate was applied to the film-forming surface of the substrate as the second liquid using a spray. Subsequently, the substrate was rotated at 2000 rpm for 30 seconds to dry the second liquid. Next, as the first liquid, an ethyl lactate solution of a copolymer of methyl methacrylate/methacrylic acid (copolymer of MMA/MAA) was added dropwise to the entire surface of the substrate in an amount of 5 ml.

Next, in a second step, the substrate was held in a stationary state until the first liquid added dropwise reached the first main surface side of the substrate through the through-hole from the second main surface side of the substrate.

In the third step, after covering the substrate with a lid close to the second main surface side of the substrate, the substrate was rotated at 1000 rpm for 60 seconds to form a thin film on the first main surface of the substrate.

Next, as the fourth step, the first liquid supplied into the through-hole, onto the second main surface, and onto the first main surface was heated and cured together with the substrate on a hotplate.

In the fifth step, a 2 ml anisole solution of methyl styrene/chloromethyl acrylate copolymer was applied as the third liquid. The rotation of the substrate in the fifth step was set to 1000 rpm for 60 seconds.

Finally, as the sixth step, the third liquid supplied onto the first thin film was heated and cured together with the substrate again using a hot plate.

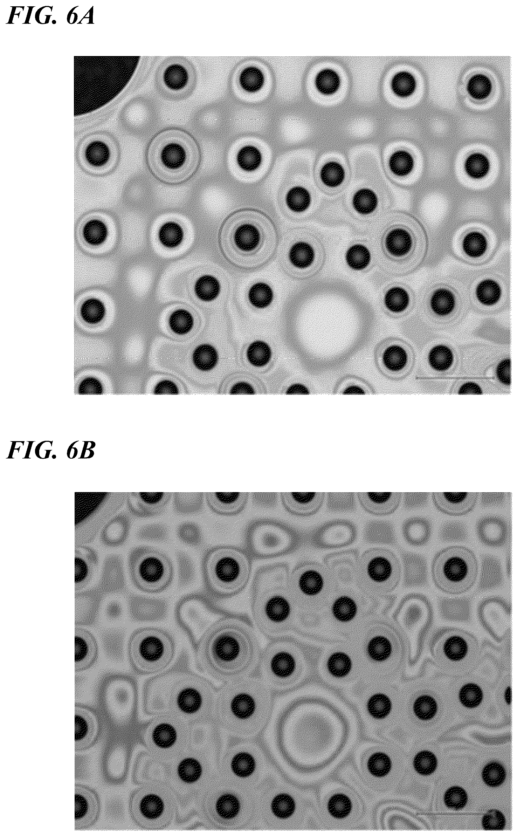

FIG. 6A is an image in which a part of the substrate on which the first film is formed after the fourth step according to the film deposition method of Example 1. FIG. 6B is an image in which the second film is formed on the first layer of FIG. 6A. In any of the images of FIG. 6A and 6B, the peripheries of the through-holes are displayed in substantially uniform interference colors, and it can be seen that substantially uniform films are formed in the first layer and the second layer.

A Manhattan-type Josephson junction pattern was drawn on the formed two-layer electron beam resist and developed. Then, deposition of the lower aluminum film, tunnel oxidation, deposition of the upper aluminum film, and removal of unnecessary resist film and aluminum film for the Josephson junction using the lift-off method were performed such that the Josephson junction was formed.

### (Example 2)

A film was formed in the same manner as in Example 1, except that the rotation of the substrate in the third step was performed at 2000 rpm for 60 seconds.

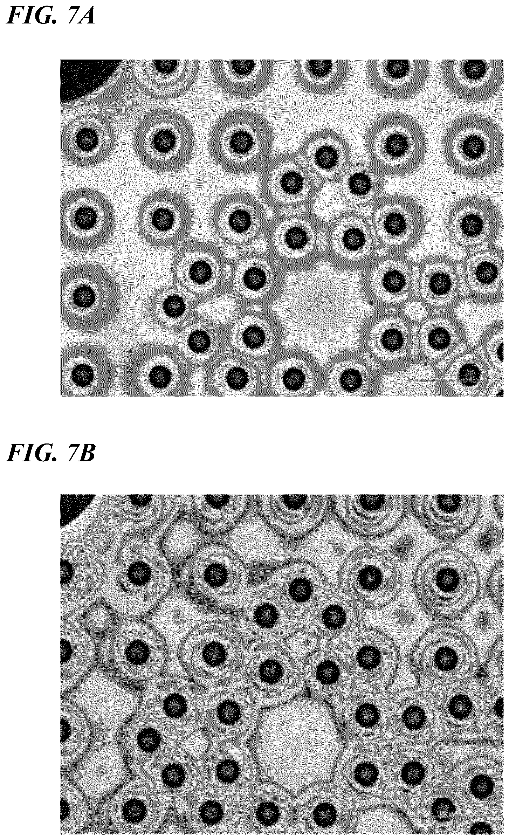

FIG. 7A is an image in which a part of the substrate on which the first film is formed after the fourth step according to the film deposition method of Example 2. FIG. 7B is an image in which the second film is formed on the first layer of FIG. 7A. In the images of FIG. 7A and 7B, the peripheries of the through-holes are displayed in interference colors with increased uniformity compared to the peripheries of the through-holes in FIGS. 6A and 6B, and it can be seen that the total film thickness uniformity of the first layer and the second layer is further enhanced. From the comparison between FIGS. 6A and 6B and FIGS. 7A and 7B, it can be seen that, as the rotation speed of the substrate increases, the first liquid can be supplied more widely and uniformly on the first main surface of the substrate, and a uniform film can be formed.

### (Comparative Example)

A film was formed on the first main surface of the same substrate as in Example 1 using the conventional spin coating method. That is, while rotating the substrate in a state where the first main surface faces a side opposite to the turntable (upper side), the same first liquid as in Example 1 was applied to the entire the first main surface, and heating was performed. The rotation of the substrate was set to 2000 rpm for 60 seconds. The coating amount of the first liquid was set to 5 ml.

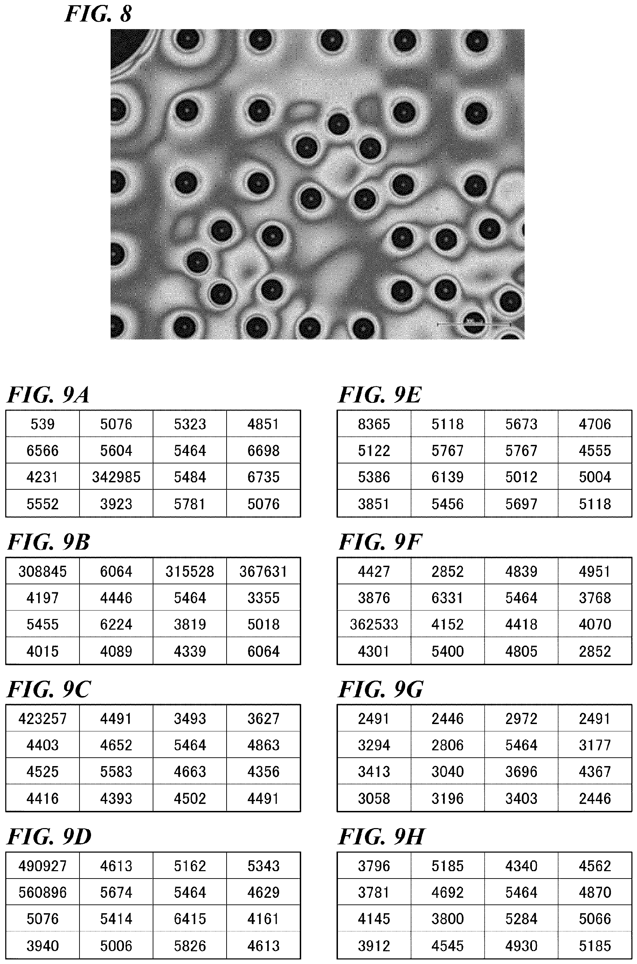

FIG. 8 is an image in which a part of a substrate on which the film is formed by a conventional film deposition method. From this image, it can be seen that regions of different colors are randomly distributed around the through-hole, and a non-uniform film is formed.

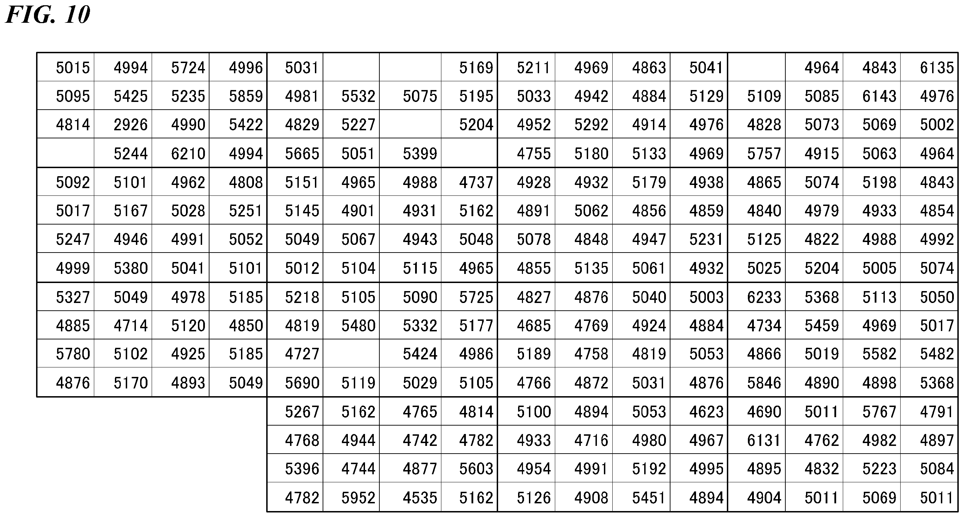

In the Comparative Example as well, a Manhattan-type Josephson junction was formed by the same process as in Example 1. As the measurement results of the resistance value of the Josephson junction when the area of the Josephson junction and the oxidation time of the tunnel oxide film are set with the target value of the electrical resistance set to 5 kS2, FIGS. 9A to 9H show the measurement data of Comparative Example, and FIG. 10 shows the measurement data of Example 1.

In FIG. 9, the resistance value of the Josephson junction varies widely from 539 S2 to 560.896 kQ. Even excluding the points where the resistance value deviates significantly, the distribution of the main resistance values varies from the 3 kΩ range to the 6 kS2 range. On the other hand, in FIG. 10, although Josephson junctions in the 2 kS2 and 6 kΩ range are seen, it can be seen that most are within the range of 4 kS2 to 5 kS2.

In general, in a Manhattan-type Josephson junction, the variation in the junction area caused by the variation in the film thickness of the electron beam resist during electron beam lithography is thought to be small. However, when the resist film thickness varies in the tunnel oxidation step, the area of the resist opening changes, and the amount of contaminant gas released from the opening surface also depends on the release area. As a result, the variation in the resist film thickness causes the variation in the resistance value of the Josephson junction. From this viewpoint, it can be said that the variation in the film thickness of the electron beam resist formed in Example 1 is smaller than the variation in the resist film thickness in the Comparative Example.

In addition, in the case of a Dolan-type Josephson junction, which is one of the methods of forming a Josephson junction, the resist film thickness significantly affects the junction area of the Dolan-type Josephson junction, and thus, when the resist film thickness varies greatly, the variation in the resistance value of the Josephson junction is also large. Therefore, even in the step of forming the Dolan-type Josephson junction, by forming the Josephson junction using the above-described coating method according to the embodiment, it is possible to reduce the variation in the resistance value of the Josephson junction as compared with a case of using the related art.

### EXPLANATION OF REFERENCES

- 100: Substrate
- 100a: First main surface of substrate
- 100b: Second main surface of substrate
- 101: Through-hole
- 103A, 103B, 103C: First thin film
- 102: Turntable
- 102a: One surface of turntable
- 102b: Substrate support portion
- 102c: Substrate fixing portion
- 102d: Lid support portion
- 103: First liquid
- 104: Lid
- 105: Heating means
- 106: Third liquid
- C: Rotation axis
- D: Thickness of substrate

## Claims

1. A film deposition method for forming a film on first main surface of a substrate having a through-hole, the method comprising:
a first step of installing the substrate on a turntable of a spin coating device such that the first main surface faces the turntable, and adding a first liquid having viscosity dropwise onto the second main surface of the substrate;
a second step of holding the substrate in the same state until the first liquid added dropwise reaches the first main surface side from the second main surface side through the through-hole;
a third step of rotating the substrate together with the turntable; and
a fourth step of heating the first liquid together with the substrate.

2. The film deposition method according to Claim 1,
wherein the first step includes a step of adding a second liquid dropwise onto the entire surface of the substrate before the first liquid is added dropwise, the second liquid consisting of a solvent that improves affinity of a liquid for forming a thin film on the second main surface, the surface of the through-hole, and the first main surface.

3. The film deposition method according to Claim 2,
wherein the solvent that improves the affinity of the second liquid is a solvent of the first liquid.

4. The film deposition method according to any one of Claims 1 to 3,
wherein the rotation in the third step is performed in a state where the second main surface side of the substrate is covered with a lid.

5. The film deposition method according to Claim 4,
wherein the lid that covers the second main surface side of the substrate rotates in synchronization with the substrate.

6. The film deposition method according to any one of Claims 1 to 3 or 5, further comprising:
a fifth step of installing the second main surface to face the turntable of the spin coating device and adding a third liquid dropwise onto the first main surface of the substrate, after the fourth step; and
a sixth step of heating the third liquid.

7. The film deposition method according to Claim 6,
wherein the same liquid as the first liquid is used as the third liquid.

8. A method for manufacturing a device using the film deposition method according to Claim 6,
wherein a predetermined circuit is formed by using a film formed by curing the first liquid through the fourth step and a film formed by curing the third liquid through the sixth step.

9. The method for manufacturing a device according to Claim 8,
wherein the first liquid is a copolymer, and the third liquid is an electron beam resist.

10. The method for manufacturing a device according to Claim 9,
wherein a solute of the first liquid is a copolymer of methyl methacrylate and methacrylic acid (copolymer of MMA/MAA), and a solvent of the first liquid is ethyl lactate.

11. The method for manufacturing a device according to Claim 9,
wherein a solute of the third liquid is a polymethyl methacrylate resin (PMMA) and a solvent of the third liquid is chlorobenzene or anisole, or the solute of the third liquid is a methyl styrene/chloromethyl acrylate copolymer and the solvent of the third liquid is anisole.

12. The method for manufacturing a device according to any one of Claims 8 to 11,
wherein the circuit is a superconducting circuit including a Josephson junction.

13. A film deposition apparatus used in the film deposition method according to any one of Claims 1 to 3 or 5,
wherein the turntable of the spin coating device facing the first main surface has no unevenness at least on a surface of a part facing the first main surface.
